# EUROPÄISCHE PATENTSCHRIFT

(11) **EP 3 224 845 B1**
(45) Veröffentlichungstag und Bekanntmachung des Hinweises auf die Patenterteilung: **05.08.2020**
(21) Anmeldenummer: 15807609.1
(22) Anmeldetag: 19.11.2015
(51) Int. Cl.: B81C 99/00, H01G 4/32, H01L 49/02

(54) **VERFAHREN ZUR HERSTELLUNG EINES AUFGEROLLTEN ELEKTRISCHEN ODER ELEKTRONISCHEN BAUELEMENTES**
METHOD FOR PRODUCING A ROLLED-UP ELECTRICAL OR ELECTRONIC COMPONENT
PROCÉDÉ DE FABRICATION D'UN COMPOSANT ÉLECTRIQUE OU ÉLECTRONIQUE ENROULÉ

(30) Priorität: 24.11.2014 DE 102014223873
(43) Veröffentlichungstag der Anmeldung: 04.10.2017
(73) Patentinhaber: Leibniz-Institut für Festkörper- und Werkstoffforschung Dresden e.V., 01069 Dresden (DE)
(72) Erfinder: GRIMM, Daniel, 01127 Dresden (DE); KARNAUSHENKO, Dmitriy, 01187 Dresden (DE); BAUER, Martin, 01187 Dresden (DE); KARNAUSHENKO, Daniil, 01187 Dresden (DE); MAKAROV, Denys, 01069 Dresden (DE); SCHMIDT, Oliver G., 01219 Dresden (DE)
(74) Vertreter: Rauschenbach, Marion
(86) Internationale Anmeldenummer: PCT/EP2015/077070
(87) Internationale Veröffentlichungsnummer: WO 2016/083227

(56) Entgegenhaltungen:
- WO-A2-2012/123348
- GB-A- 811 983
- GOLOD S V ET AL: "Freestanding SiGe/Si/Cr and SiGe/Si/SixNy/Cr microtubes", APPLIED PHYSICS LETTERS, AMERICAN INSTITUTE OF PHYSICS, 2 HUNTINGTON QUADRANGLE, MELVILLE, NY 11747, Bd. 84, Nr. 17, 26. April 2004 (2004-04-26), Seiten 3391-3393, XP012061258, ISSN: 0003-6951, DOI: 10.1063/1.1736317
- YA PRINZ V ET AL: "A new technique for fabricating three-dimensional micro- and nanostructures of various shapes; A new technique for fabricating three-dimensional micro- and nanostructures of various shapes", NANOTECHNOLOGY, IOP, BRISTOL, GB, Bd. 12, Nr. 4, 1. Dezember 2001 (2001-12-01), Seiten 399-402, XP020066812, ISSN: 0957-4484, DOI: 10.1088/0957-4484/12/4/301

## Beschreibung

Die vorliegende Erfindung bezieht sich auf die Gebiete der Physik, der Werkstoffwissenschaften und der Mikro- und Nanoelektronik und betrifft ein Verfahren zur Herstellung eines aufgerollten elektrischen oder elektronischen Bauelementes, wie es beispielsweise in elektrischen und elektronischen Bauelementen als Kondensator, oder in induktiven und/oder resistiven dreidimensionalen Elementen oder in Antennen eingesetzt werden kann.

Unsere elektronisch mobile Gesellschaft fordert immer neue Errungenschaften/Verbesserungen, um ultrakompakte integrative Bauelemente für die mobile Benutzung unterwegs komfortabel nutzen zu können. Kondensatoren sind in nahezu allen elektrischen und elektronischen Geräten zu finden.

Für die elektrische Kapazität eines Kondensators ist die Fläche der elektrisch leitenden Schicht von Bedeutung. Je größer diese Fläche ist, desto größer ist die elektrische Kapazität.

Dabei ist jedoch zu beachten, dass Kondensatoren als elektrische Bauelemente in elektrischen oder elektronischen Geräten eingebaut werden. Die dafür benötigte Baufläche sollte daher so gering wie möglich sein. Je geringer diese Baufläche ist, desto kleiner kann das elektrische oder elektronische Gerät gebaut werden.
Dafür wurden die Entwicklungen in letzter Zeit auf die Miniaturisierung in der Mikroelektronik, besonders auf die Verkleinerung der Größe von Transistoren und von diskreten passiven Elementen, wie Induktoren oder Kondensatoren, konzentriert [R. Sharma et al., Adv. Energy Mater., 2014, 4, 1301631].

Bei der Roll-up-Technologie werden Schichten auf ein Substrat aufgebracht und diese nachfolgend aufgerollt. Der Mechanismus des Aufrollens wird durch Aufbringen der Schichten in einem Verspannungszustand und nachfolgendes Entspannen durch Ablösen der Schichten vom Substrat erlangt.

Bekannt ist gemäß WO 2010/129319 A2 das Plasma- oder nasschemische Ätzen eines Siliziumsubstrates, so dass die darauf abgeschiedene, verspannte zweidimensionale Struktur aufgerollt wird und zu einer dreidimensionalen Struktur geformt wird.
Gemäß Bufon sind Schichtaufbauten bekannt, die auf einer Opferschicht angeordnet sind und durch Entfernen der Opferschicht aufgerollt werden. Die Geschwindigkeit, mit der sich die Opferschicht unterätzen lässt und sich die verspannte Schicht vom Substrat trennt beträgt dabei maximal 100 µm/h [C.C.B. Bufon et al., Nano Letters, 2010, 10, 2506-2510].

Auch gemäß der EP 2 023 357 B1 ist ein Verfahren zur Herstellung von Kondensatoren bekannt, bei dem ein Schichtaufbau durch Auflösung einer Opferschicht aufgerollt wird. Als unterer Teil des Schichtaufbaus kann auch ein Hydrogel verwendet werden, das in Kontakt mit Wasser gebracht wird, dabei das Wasser absorbiert, aufquillt und zum Aufrollen des Schichtstapels führt (V. Luchnikov et al., Advanced Materials 2005, 17, 1177-1182).

Gemäß der DE 101 59 415 B4 ist die Herstellung mikro- und nanoskopischer Spulen, Transformatoren und Kondensatoren durch Einrollen oder Umklappen von Leiterschichten beim Ablösen von Hilfsschichten von einem Substrat bekannt. Dazu wird eine zuvor zwischen einer Leiterbahn und einem Substrat aufgebrachte Hilfsschicht von dem Substrat abgelöst und die Leiterbahn in Folge dessen aufgerollt. Dabei wird als Hilfsschicht Germanium oder Aluminiumarsenid verwendet. Ebenso wird nach Sharma Ge/GeOₓ als Opferschicht verwendet und diese mittels einer nassätzenden Lösung, 2 % H₂O₂, entfernt [R. Sharma et al., Adv. Energy Mater., 2014, 4, 1301631]. Weiterhin können fluidische Sensorelemente mit einer ähnlichen Ätztechnik hergestellt werden [C. S. Martinez-Cisneros et al., Nano Lett. 2014, 14, 2219]. Bekannt ist auch der Einsatz von H₂O₂ um verspannte Multilagen aus nahezu einkristallinen Si und Ge vom Substrat zu entfernen, um Mikrohelixstrukturen für elektromechanische Sensorik-Elemente herzustellen [D.J. Bell et al., Sensors & Actuators A 2006, 130, 54-61].

Weitere aufgerollte Mikro-Bauteile nutzen andere anorganische Opferschichten. Aluminiumarsenid (AlAs) wird im Falle von aufgerollten Transistoren als Opferschicht eingesetzt [D. Grimm et al., Nano Lett. 2013, 13, 213]. Die AlAs Opferschicht wird durch eine Mischung aus nassätzendem HCl oder HF entfernt.

Gemäß [I. Mönch et al., Smart Mater. Struct. 2011, 20, 85016] können aufgerollte Widerstände hergestellt werden, indem ein 1.5 µm dicker Photolack als Opferschicht eingesetzt wird. Dieser Photolack wird durch Lösungsmittel, üblicherweise Aceton, entfernt. Weitere Anwendungen, die mit ähnlicher Ätztechnik hergestellt werden, beinhalten mikrofluidische Sensorelemente [S. M. Harazim et al., Lab Chip 2012, 12, 2649] und Mikro-Batterien mit großer aktiver Oberfläche pro Volumen [C. Yan et al., Adv. Mater. 2013, 25, 539; J. Deng et al., Angew. Chem. 2013, 125, 2382]. Die Patentanmeldung WO 2012/123348 A2 lehrt ein Verfahren wonach eine Opferschicht aus Photolack auf ein Glassubstrat aufgetragen wird. Die nachfolgend aufgebrachten Metall- bzw. Isolatorschichten bilden einen Schichtstapel, der sich bei Auflösen des Photolacks in Aceton selbsttätig aufrollt.

Nachteilig an dem bekannten Stand der Technik ist, dass die Herstellung aufgerollter Bauteile wie etwa Kondensatoren, Antennen, Widerstände und Spulen vorteilhafterweise große aktive Bauteilflächen und daher lange Rolllängen mit einer vergleichsweise langen Dauer für den Aufrollprozess benötigen.

Im Falle des Einsatzes einer Opferschicht muss diese mittels selektivem Ätzens entfernt werden. Als Ätzmedium wird beispielsweise verdünntes Wasserstoffperoxid, Säure oder organische Lösungsmittel eingesetzt, die für die menschliche Haut schädlich sind. Auch der Einsatz von Wasser im Falle einer GeOₓ-Opferschicht ist bekannt, wobei jedoch nur sehr geringe Aufrollgeschwindigkeiten erreicht werden können. Bei längerer Anwendung wirken insbesondere Wasserstoffperoxid, Säuren und DI Wasser korrodierend auf Metallschichten und sind daher ein großer Nachteil bei langen Rollzeiten. Der Einsatz von Photolack als Opferschicht für Bauteile mit langen Rolllängen ist nicht möglich, da die nötigen photolithographischen Prozessschritte den Einsatz von Lösungsmitteln verlangen, die wiederum die Photolack-Opferschicht angreifen.

Von Nachteil ist weiter, dass ein gerades Aufrollen der Schichtstapel über lange Distanzen nicht reproduzierbar gewährleistet werden kann und dadurch die nutzbare Aufrolllänge begrenzt ist.

Die Aufgabe der vorliegenden Erfindung besteht in der Angabe eines kostengünstigen, umweltfreundlichen und zeitsparenden Verfahrens zur Herstellung eines aufgerollten elektrischen oder elektronischen Bauelementes mit vielen Windungen.

Die Aufgabe wird durch die in Anspruch 1 angegebene Erfindung gelöst.

Vorteilhafte Ausgestaltungen der Erfindung sind Gegenstand der Unteransprüche. Bei dem erfindungsgemäßen Verfahren zur Herstellung eines aufgerollten Bauelementes werden auf ein Substrat mit einer Opferschicht mindestens zwei übereinander angeordnete Funktions- und Isolationsschichten aufgebracht, wobei mindestens die Funktions- oder Isolationsschicht, die direkt auf der Opferschicht angeordnet ist, mindestens an den beiden Seiten, die im Wesentlichen parallel zur Rollrichtung angeordnet sind, eine Perforierung aufweist.

Vorteilhafterweise besteht die Perforierung aus einer stegartigen Strukturierung und die Stege besitzen eine viereckige Grundform.

Ebenfalls vorteilhafterweise ist bei der viereckigen Grundform der Stege eine der Seiten der Stege im Wesentlichen parallel zur Rollrichtung der Schichten angeordnet und Bestandteil des Randes der aufzurollenden Schicht und weist eine Seitenlänge (B) von 1 bis 1000 µm auf, und die andere Seite der Stege im Wesentlichen parallel zur Rollrichtung der Schichten ist in einem Abstand (H) von 5 bis 200 µm zum Rand der aufzurollenden Schicht angeordnet und weist einen Abstand zwischen den Stegen von 20 bis 4000 µm auf, und der Winkel (α) zwischen der Seite der Stege, die zuerst in Rollrichtung vorhanden ist, und dem Rand der aufzurollenden Schicht außerhalb des Steges beträgt zwischen 15 und 135 °, und der Winkel (β) zwischen der Seite der Stege, die zuletzt in Rollrichtung vorhanden ist, und dem Rand der aufzurollenden Schicht außerhalb des Steges beträgt zwischen 45 bis 135 °, und nachfolgend wird die Opferschicht ganz oder teilweise entfernt und der Schichtstapel aufgerollt.

Weiterhin vorteilhafterweise wird als Substrat ein starres oder flexibles Material eingesetzt.

Und auch vorteilhafterweise wird ein Substrat aus Silizium, Siliziumoxid, Glas, Keramik oder eine Folie aus Polyethylenterephthalat (PET) oder Polyetheretherketon (PEEK) und eine Opferschicht aus Polyvinylalkohol (PVA), Polyacrylsäure (PAA), Biopolysaccharide, Celluloseacetat, Polyallylamin (PAH), Methylcellulose oder Ethylcellulose eingesetzt.

Vorteilhaft ist es auch, wenn als Funktionsschichten Schichten aus einem elektrisch leitenden Material und als Isolationsschichten Schichten aus einem dielektrischen und/oder elektrisch isolierenden Material mittels Atomlagenabscheidung und/oder chemischer Gasphasenabscheidung aufgebracht werden.

Ebenfalls vorteilhaft ist es, wenn ein Schichtstapel auf die Opferschicht aufgebracht wird, der aus einer Schicht aus mindestens einem dielektrischen und/oder elektrisch isolierenden Material, einer Schicht aus mindestens einem ersten elektrisch leitenden Material, einer weitere Schicht aus mindestens einem dielektrischen und/oder elektrisch isolierenden Material und einer Schicht aus mindestens einem zweiten elektrisch leitenden Material besteht, und bei dem die Schichten aus dem dielektrischen und/oder elektrisch isolierenden Material die Schichten aus dem elektrisch leitenden Material im Wesentlich vollständig bedecken.

Weiterhin vorteilhaft ist es, wenn als Material für elektrisch leitfähige Schichten Ti, Cr, Al, Au, Ni, Pd, Cu, W, Ta sowie deren Verbindungen, oder Indiumzinnoxid oder hochdotiertes Halbleitermaterial eingesetzt wird.

Und auch vorteilhaft ist es, wenn als Material für dielektrische und/oder isolierende Schichten AlOₓ, vorteilhafterweise Al₂O₃, SiOₓ, vorteilhafterweise SiO₂, AlTiOₓ, SiTiOₓ, HfOₓ, TaOₓ, ZrOₓ, HfSiOₓ, ZrSiOₓ, TiZrOₓ, TiZrWOₓ, TiOₓ, SrTiOₓ, PbTiOₓ, SiAlOₓ, Metallnitride, Aluminiumnitride AlN_{y}, Siliziumnitride SiN_{y}, AlScN_{y}, Metalloxynitride, Aluminiumoxynitride AlOₓN_{y}, Siliziumoxynitride SiOₓN_{y}, HfSiOₓN_{y} und/oder SiC_{z}OₓN_{y} eingesetzt wird.

Von Vorteil ist es auch, wenn mindestens eine Schicht, die direkt auf die Opferschicht aufgebracht wird, eine Aufrolllänge von 1 mm bis 30 mm aufweist.

Und auch von Vorteil ist es, wenn Funktions- und Isolationsschichten übereinander auf der Opferschicht angeordnet werden, die an beiden Seiten parallel zur Rollrichtung hinsichtlich Anzahl und Geometrie der Stege die gleiche stegartige Strukturierung aufweisen.

Ebenfalls von Vorteil ist es, wenn Funktions- und Isolationsschichten aufgebracht werden, bei denen die Seite der Stege, die im Wesentlichen parallel zur Rollrichtung der Schichten angeordnet und Bestandteil des Randes der aufzurollenden Schicht sind, eine Seitenlänge (B) von 10 bis 200 µm aufweisen.

Weiterhin von Vorteil ist es, wenn Funktions- und Isolationsschichten aufgebracht werden, bei denen die Seite der Stege, die parallel zur Rollrichtung der Schichten angeordnet ist und nicht Bestandteil des Randes der aufzurollenden Schicht ist, oder eine Ecke der Stege in einem Abstand (H) zum Rand der aufzurollenden Schicht von 10 bis 50 µm angeordnet sind.

Vorteilhaft ist es auch, wenn Funktions- und Isolationsschichten aufgebracht werden, bei denen der Abstand (D) zwischen den Stegen in Rollrichtung 20 bis 500 µm beträgt.

Und auch vorteilhaft ist es, wenn Funktions- und Isolationsschichten aufgebracht werden, bei denen der Winkel (α) zwischen der Seite des Vierecks der Stege, der zuerst in Rollrichtung vorhanden ist, und dem Rand der aufzurollenden Schicht außerhalb des Vierecks zwischen 30 bis 120 °, noch vorteilhaftweise 45 °, und der Winkel (β) zwischen der Seite des Vierecks der Stege, der zuletzt in Rollrichtung vorhanden ist, und dem Rand der aufzurollenden Schicht außerhalb des Vierecks zwischen 80 bis 120 °, noch vorteilhafterweise 90 ° beträgt.

Weiterhin vorteilhaft ist es, wenn die Opferschicht mittels Ätzens oder mittels organischer Lösungsmittel und/oder Wasser und/oder Ethylendiamintetraessigsäure entfernt wird.

Mit der erfindungsgemäßen Lösung ist es erstmals möglich, ein kostengünstiges, umweltfreundliches und zeitsparendes Verfahren zur Herstellung eines aufgerollten elektrischen oder elektronischen Bauelementes mit vielen Windungen anzugeben.

Erreicht wird dies durch ein Verfahren, bei dem auf ein starres oder flexibles Substrat, beispielsweise aus Silizium, Siliziumoxid, Glas, Keramik oder eine Folie, beispielsweise aus Polyethylenterephthalat (PET) oder Polyetheretherketon (PEEK) eine Opferschicht aufgebracht wird.

Die Opferschicht kann beispielsweise aus wasserlöslichen Polymeren, wie Polyvinylalkohol (PVA), Polyacrylsäure (PAA), Biopolysaccharide, Celluloseacetat, Polyallylamin (PAH), Methylcellulose oder Ethylcellulose bestehen. Alternativ kann jedes Polymer, das stabil bei photolithographischen Prozessschritten und nass- oder trockenchemisch ätzbar ist, eingesetzt werden. Die Opferschicht hat dabei Dicken von 5 nm - 100 µm, vorteilhafterweise unter 500 nm.

Auf die Opferschicht wird dann entweder eine Funktionsschicht oder eine Isolationsschicht, beispielsweise mittels Atomlagenabscheidung und/oder chemischer Gasphasenabscheidung, aufgebracht. Das Material und die Abmessungen der Funktions- und Isolationsschichten richten sich nach dem herzustellenden aufgerollten elektrischen oder elektronischen Bauelement.

Im Falle der Herstellung eines Kondensators wird beispielsweise ein Schichtstapel auf die Opferschicht aufgebracht, der aus einer Schicht aus mindestens einem dielektrischen und/oder elektrisch isolierenden Material, einer Schicht aus mindestens einem ersten elektrisch leitenden Material, einer weiteren Schicht aus mindestens einem dielektrischen und/oder elektrisch isolierenden Material und einer Schicht aus mindestens einem zweiten elektrisch leitenden Material besteht und bei dem die Schichten aus dem dielektrischen und/oder elektrisch isolierenden Material die Schichten aus dem elektrisch leitenden Material im Wesentlich vollständig bedecken.

Als Material für elektrisch leitfähige Schichten können beispielsweise Ti, Cr, Al, Au, Ni, Pd, Cu, W, Ta, sowie deren Verbindungen, oder Indiumzinnoxid oder hochdotiertes Halbleitermaterial eingesetzt wird, und als Material für dielektrische und/oder isolierende Schichten können beispielsweise AlOₓ, vorteilhafterweise Al₂O₃, SiOₓ, vorteilhafterweise SiO₂, AlTiOₓ, SiTiOₓ, HfOₓ, TaOₓ, ZrOₓ, HfSiOₓ, ZrSiOₓ, TiZrOₓ, TiZrWOₓ, TiOₓ, SrTiOₓ, PbTiOₓ, SiAlOₓ, Metallnitride, Aluminiumnitride AlN_{y}, Siliziumnitride SiN_{y}, AlScN_{y}, Metaloxynitride, Aluminiumoxynitride AlOₓN_{y}, Siliziumoxynitride SiOₓN_{y}, HfSiOₓN_{y} und/oder SiC_{z}OₓN_{y} eingesetzt werden.

Erfindungswesentlich ist, dass mindestens die Funktions- oder Isolationsschicht, die direkt auf der Opferschicht angeordnet ist, mindestens an den beiden Seiten, die im Wesentlichen parallel zur Rollrichtung angeordnet sind, eine Perforierung aufweist.

Unter Perforation im Rahmen dieser Erfindung soll eine Art Zähnung der Seiten der Schichten, die im Wesentlichen parallel zur Rollrichtung angeordnet sind, in Form von Stegen verstanden werden, die vorteilhafterweise eine viereckige Grundform aufweisen.

Die erfindungsgemäße Perforierung besteht aus einer möglichst regelmäßigen Anordnung von einer Vielzahl von geometrisch gleichen oder unterschiedlichen Stegen, die gegenüber den Abmessungen der Schichten oder des Schichtstapels Abmessungen aufweisen, die um mindestens eine Größenordnung kleiner sind, und die vorteilhafterweise vollständig über den seitlichen Rand der aufzurollenden Schicht oder Schichten im Wesentlichen parallel zur Rollrichtung hinausragen und die nach dem Aufrollen der Schichten möglichst vollständig auf der Opferschicht verbleiben und nicht mehr Bestandteil des erfindungsgemäßen aufgerollten elektrischen oder elektronischen Bauelementes sind.
Sowohl die Form der Stege als auch ihre Anordnung im Verhältnis zu den aufzurollenden Schichten ist dabei von besonderer Bedeutung.

Diese Perforierung der mindestens untersten Schicht auf der Opferschicht wirkt als Sollbruchstelle beim Aufrollen des Schichtstapels.
Eine Sollbruchstelle ist ein durch konstruktive oder mechanische oder physikalische Maßnahmen oder Auslegungen vorgesehenes Konstruktionselement.

Erfindungsgemäß werden Stege eingesetzt, die eine viereckige Grundform aufweisen und mindestens Bestandteil der unmittelbar auf der Opferschicht angeordneten Schicht des aufzurollenden Schichtstapels auf dem Substrat sind und an deren Seitenrändern jeweils parallel zur Rollrichtung angeordnet sind.

Die Stege sind immer mit mindestens einer Seite ihrer viereckigen Grundform mit der Schicht stofflich verbunden. Diese Seite (B) hat Abmessungen von 1 bis 1000 µm, vorteilhafterweise von 10 bis 200 µm, und ist immer Teil des Randes der jeweiligen Schicht und entspricht der Sollbruchstelle, das heißt, an dieser Seite soll während des Aufrollens eine Trennung des Schichtmaterials vom Stegmaterial erfolgen.

Bei der viereckigen Grundform der Stege sind zwei Seiten des Vierecks im Wesentlichen parallel, und möglichst vollständig parallel zur Rollrichtung und zwei Seiten nichtparallel zur Rollrichtung ausgeführt. Die eine Seite parallel zur Rollrichtung ist Bestandteil des Randes der aufzurollenden Schicht und die andere Seite parallel zur Rollrichtung befindet sich in einem Abstand (H) zum Rand der aufzurollenden Schicht, wobei der Abstand 5 bis 200 µm, vorteilhafterweise 10 bis 50 µm beträgt. Die beiden nichtparallelen Seiten des Viereckes der Stege sind in einem Winkel zur Rollrichtung angeordnet. Dabei beträgt der Winkel (α) zwischen der Seite des Vierecks der Stege, die zuerst in Rollrichtung vorhanden ist, und dem Rand der aufzurollenden Schicht außerhalb des Vierecks zwischen 15 und 135 °, vorteilhafterweise 30 bis 120 °, noch vorteilhaftweise 45 °, und der Winkel (β) zwischen der Seite des Vierecks der Stege, die zuletzt in Rollrichtung vorhanden ist, und dem Rand der aufzurollenden Schicht außerhalb des Vierecks zwischen 45 bis 135 °, vorteilhafterweise 80 bis 120 °, noch vorteilhafterweise 90 °.

Der Abstand (D) zwischen den Stegen in Rollrichtung beträgt 20 bis 4000 µm, vorteilhafterweise 20 bis 500 µm. Dies betrifft im Wesentlichen den Abstand zwischen den Stegen am Rand der aufzurollenden Schicht. Es ist auch möglich, dass eine Ecke eines Steges eine Ecke des benachbarten Steges berührt und/oder mit ihr stoffschlüssig verbunden ist. Das dadurch gebildete Loch zwischen den Stegen kann dann dreieckig ausgebildet sein.

Vorteilhafterweise weisen alle Funktions- und Isolationsschichten, die übereinander auf der Opferschicht angeordnet werden, an beiden Seiten im Wesentlichen parallel zur Rollrichtung die gleiche Perforation auf.

Es ist auch möglich, auf den beiden Seiten der Schicht oder Schichten hinsichtlich Form und Größe und Abstand zueinander unterschiedliche Perforationen herzustellen. Dadurch kann eine gezielte Beeinflussung der Rollrichtung realisiert und beispielsweise Spulen hergestellt werden.

Bei dem erfindungsgemäß hergestellten Schichtstapel, von dem mindestens die unterste Schicht auf der Opferschicht eine Perforation mit den erfindungsgemäß angegebenen Formen und Abmessungen der Stege aufweist, und der eine Aufrolllänge von 1000 µm bis 30 mm aufweisen kann, wird nachfolgend ganz oder teilweise die Opferschicht entfernt. Dies erfolgt beispielsweise durch Ätzen oder durch Anwendung eines organischen Lösungsmittels oder von Wasser.
Während des mindestens teilweisen Entfernens der Opferschicht wird der Schichtstapel aufgerollt. Der Durchmesser des aufgerollten Schichtstapels kann zwischen 10 und 100 µm betragen.

Mit der erfindungsgemäßen Lösung wird es erstmals möglich, Schichtstapel für aufgerollte elektrische oder elektronische Bauelemente mit großen Aufrolllängen zur Erlangung vieler Windungen sicher und gerade aufzurollen. Dies trifft insbesondere für Aufrolllängen von 1 mm bis 30 mm zu.

Bei den Lösungen des Standes der Technik bereiten insbesondere der Anfang des Aufrollens und vor allem die Ecken eines Schichtstapels bei der Entfernung der Opferschicht Probleme, da in den Ecken die Opferschicht zuerst und schneller entfernt wird. Nach dem Aufrollen von üblicherweise 0.5 - 1mm Länge des Schichtstapels rollen die Ecken auch auf, so dass oft keine gleichmäßige Aufrollfront realisiert werden kann und der Aufrollvorgang gestoppt wird.
Mit dem erfindungsgemäßen Verfahren werden nun diese unterschiedlichen Aufrollgeschwindigkeiten zeitlich und örtlich dahingehend ausgeglichen, dass die Kraft für das Aufrollen insbesondere an den Ecken und Seiten des aufzurollenden Schichtstapels in Rollrichtung mindestens teilweise für das Ablösen und/oder Abreißen der Stege vom Rand des jeweiligen Schichtmaterials während des Aufrollvorganges aufgewandt werden muss.

Die besondere geometrische Form der Stege sichert dabei ein sicheres Ablösen des Materials der Stege oder das Abreißen dieses Materials der Stege vom aufzurollenden Schichtstapel während des Aufrollens. Im Bereich der Löcher der Perforation wird die Entfernung der Opferschicht über den Abstand zwischen den Stegen in Rollrichtung ohne das Schichtmaterial durchgeführt, so dass während dieser Zeit wenig Spannungen auf den aufzurollenden Schichtstapel einwirken und damit der Aufrollvorgang über die gesamte Aufrollfront einfach, leicht und ausschließlich in Rollrichtung realisiert wird.

Nachfolgend wird die Erfindung an mehreren Ausführungsbeispielen näher erläutert.

### Dabei zeigen

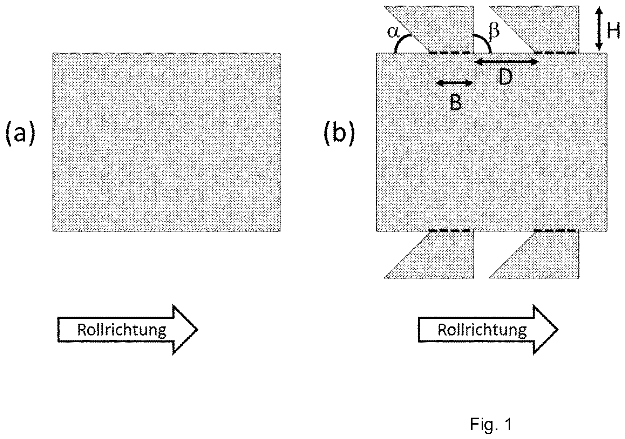

- Fig. 1a: eine aufzurollende Schicht nach dem Stand der Technik
- Fig. 1b: eine aufzurollende Schicht mit einer Perforation

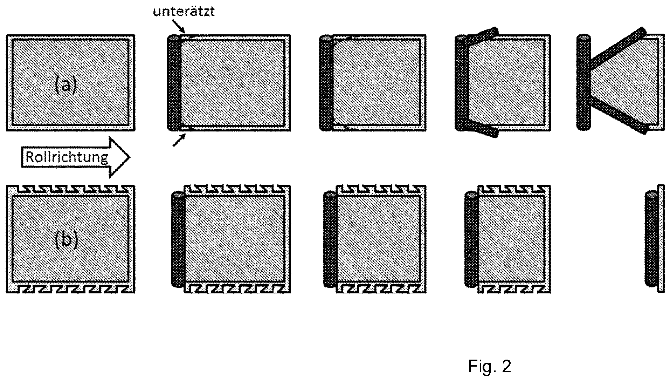

- Fig. 2a: ein Ablaufschema des Rollprozesses einer Schicht nach dem Stand der Technik
- Fig. 2b: ein Ablaufschema des Rollprozesses einer Schicht mit einer Perforation

### Beispiel 1: Kondensatoren

Zur Herstellung eines ultrakompakten Mikrokondensators mit vielen Windungen wird auf ein Silizium-Substrat mit einer Länge von 20 mm und einer Breite von 5 mm mit einer 1 µm-dicken thermisch aufgebrachten Siliziumdioxidschicht vollständig bedeckend eine Schicht Methylcellulose in einer Zentrifuge mit einer Umdrehungsgeschwindigkeit von 4500 rpm (Umdrehungen pro Minute) aufgeschleudert und anschließend auf einer Heizplatte bei 120 °C 5 Minuten ausgeheizt und getrocknet. Diese Schicht aus Methylcellulose, die dünner als 5nm ist, ist die Opferschicht.

Nachfolgend wird mittels des Verfahrens der Atomlagendeposition eine 11 nm dicke Al₂O₃-Schicht vollständig die Opferschicht bedeckend bei 150 °C abgeschieden. Diese dielektrisch wirkende Al₂O₃-Schicht dient auch als Isolationsschicht zwischen den beiden metallischen Elektroden nach dem Aufrollen und zum Schutz der Opferschicht vor den folgenden Prozessschritten und der Luftfeuchtigkeit.
Mit Hilfe der optischen Photolithographie wird die erste Elektrode des Kondensators mit einer Länge von 10 mm in Rollrichtung und einer Breite von 0.6 mm strukturiert. Mittels Elektronenstrahlverdampfung wird eine verspannte elektrisch leitende Schicht bestehend aus 15 nm Ti und nachfolgend 20 nm Cr mit einer Rate von jeweils 0.1 nm/s abgeschieden und anschließend geliftet. Die Schicht weist eine Perforation mit Stegen mit einer viereckigen Grundform an beiden Seiten der Schicht parallel zur Rollrichtung auf und ist durch eine Maske während der Abscheidung der Schicht realisiert worden. Die Perforation besteht an beiden Seiten aus geometrisch gleichen und gleichgroßen Stegen, ist angepasst auf den zu erwartenden Roll-Durchmesser von 50 µm und weist folgende Abmessungen auf
Höhe der Stege: H = 9 µm,
Breite der Stege am Rand der Schicht: B = 25 µm,
Abstand der Stege am Rand der Schicht: D = 25 µm,
erster Winkel in Rollrichtung: α = 21°,
zweiter Winkel in Rollrichtung: β = 78°.
Danach wird eine zweite 11 nm dicke Al₂O₃-Schicht wieder mittels Atomlagendeposition vollständig die erste elektrisch leitende Schicht bedeckend jedoch ohne Perforation an den Seiten bei 150 °C abgeschieden.

Nach der optischen Lithographie für die zweite Elektrode folgt die Abscheidung der zweiten elektrisch leitfähigen Schicht ebenfalls wieder ohne stegartige Strukturierung an den Seiten von 10 nm Cr mit einer Rate von 0.1 nm/s und anschließendem Liftoff. Abschließend wird die überstehende Opferschicht mittels Wasser entfernt und der verspannte Schichtstapel mit einer Geschwindigkeit von 2 mm/min aufgerollt.

Durch Einsatz der erfindungsgemäßen Perforation konnte der Aufrollvorgang über die gesamte Aufrolllänge über die gesamte Aufrollfront immer in Rollrichtung und mit einer hohen Aufrollgeschwindigkeit realisiert werden.
Auf diese Art und Weise konnte mit einem kostengünstigen, umweltfreundlichen und zeitsparenden Verfahren ein aufgerollter Kondensator hergestellt werden.

### Beispiel 2: Antenne

Zur Herstellung einer dreidimensionalen Antenne wird auf ein Glassubstrat von 22x22 mm² und einer Dicke von 200 µm vollständig bedeckend eine Schicht aus einer 4% (w/v) verdünnten Polyacrylsäure (PAA) bei 3000 rpm aufgeschleudert. Die finale Schichtdicke dieser Opferschicht beträgt 500 nm. Diese Schicht wird für 2 Minuten bei 35 °C getrocknet und anschließend in einer 1 molaren Lösung aus CaCl₂ in deionisiertes (DI) Wasser eingetaucht. Anschließend wird das beschichtete Substrat in DI Wasser gewaschen und getrocknet. Mittels Standard-Photolithographie wird die Grundfläche der Antenne mittels Photolack AR-P3510 strukturiert. Die PAA-Opferschicht wird an den unbeschichteten Stellen mit unverdünntem Entwickler AR300-35 entfernt und in DI Wasser gewaschen. Der Photolack wird in Aceton entfernt und das beschichtete Substrat in Isopropanol gewaschen und getrocknet. Auf diese Opferschicht wird ein verspannter Schichtstapel aus organischen Materialien aufgebracht. Die erste Schicht besteht aus PAA (M_{w}=150000) und PVA im Verhältnis 1:1, 4% (w/v) verdünnt in Wasser. Die zweite Schicht besteht aus Polyimid (M_{w}=100000), 2% (w/v) verdünnt in N-Methyl-2-Pyrolidon. Die erste Polymer-Schicht wird bei 8000 rpm ganzflächig auf die Opferschicht mit einer resultierenden Schichtdicke von 500 nm aufgebracht. Diese Schicht wird mittels Standard Photolithographie und unverdünntem Entwickler strukturiert, wobei die Schicht an beiden Seiten der Schicht parallel zur Rollrichtung die Perforation mit Stegen mit einer viereckigen Grundform und den folgenden Abmessungen aufweist:
Höhe der Stege: H = 200 µm,
Breite der Stege am Rand der Schicht: B = 100 µm,
Abstand der Stege am Rand der Schicht: D = 300 µm,
erster Winkel in Rollrichtung: α = 45°,
zweiter Winkel in Rollrichtung: β = 90°.
Die Perforation besteht an beiden Seiten aus geometrisch gleichen und gleichgroßen Stegen,
Auf die verspannte Schicht folgt die Abscheidung der Metallschicht ohne Perforation. Hierzu wird mittels Standard Photolithographie der Photolack strukturiert und Ta(10 nm)/Cu(100 nm)/Ta(10 nm) mittels Magnetron-Sputtern abgeschieden. Hierbei wird Ar bei einem Partialdruck von 0,1 Pa als Sputter-Gas eingesetzt. Der Liftoff erfolgt durch Aceton und abschließendem Spülen in Isopropanol.

Die so hergestellten planaren zweidimensionalen Strukturen mit einer Grundfläche von 5.5x17 mm² werden durch Ablösen vom Substrat zu dreidimensionalen spiralförmigen Antennen aufgerollt. Das Ablösen wird mittels selektiven Ätzens der Opferschicht in einer 0.5 molaren Ethylendiamintetraessigsäure (EDTA)-Lösung erreicht. Nach dem Rollprozess werden die Antennen in DI Wasser gewaschen und an Luft getrocknet. Der Durchmesser der aufgerollten Antenne beträgt 300 µm und die Länge nach dem Rollen beträgt 5.5 mm.

Durch Einsatz der erfindungsgemäßen Perforation konnte der Aufrollvorgang über die gesamte Aufrolllänge über die gesamte Aufrollfront immer in Rollrichtung und mit einer hohen Aufrollgeschwindigkeit realisiert werden.
Auf diese Art und Weise konnte mit einem kostengünstigen, umweltfreundlichen und zeitsparenden Verfahren eine aufgerollte Antenne hergestellt werden.

## Patentansprüche

1. Verfahren zur Herstellung eines aufgerollten Bauelementes, bei dem auf ein Substrat mit einer Opferschicht mindestens zwei übereinander angeordnete Funktions- und Isolationsschichten aufgebracht werden, und nachfolgend die Opferschicht ganz oder teilweise entfernt und der Schichtstapel aufgerollt wird, **dadurch gekennzeichnet, dass** mindestens die Funktions- oder Isolationsschicht, die direkt auf der Opferschicht angeordnet ist, mindestens an den beiden Seiten, die im Wesentlichen parallel zur Rollrichtung angeordnet sind, eine Perforierung aufweist, und durch das ganz oder teilweise Entfernen der Opferschicht sich der Schichtstapel selbsttätig aufrollt, wobei die Perforierung als Sollbruchstelle wirkt.

2. Verfahren nach Anspruch 1, bei der die Perforierung aus einer stegartigen Strukturierung besteht und die Stege eine viereckige Grundform besitzen.

3. Verfahren nach Anspruch 2, bei dem bei der viereckigen Grundform der Stege eine der Seiten der Stege im Wesentlichen parallel zur Rollrichtung der Schichten angeordnet und Bestandteil des Randes der aufzurollenden Schicht ist und eine Seitenlänge (B) von 1 bis 1000 µm aufweist, und die andere Seite der Stege im Wesentlichen parallel zur Rollrichtung der Schichten in einem Abstand (H) von 5 bis 200 µm zum Rand der aufzurollenden Schicht angeordnet ist, und der Abstand zwischen den Stegen 20 bis 4000 µm aufweist, und der Winkel (α) zwischen der Seite der Stege, die zuerst in Rollrichtung vorhanden ist, und dem Rand der aufzurollenden Schicht außerhalb des Steges zwischen 15 und 135 °, und der Winkel (β) zwischen der Seite der Stege, die zuletzt in Rollrichtung vorhanden ist, und dem Rand der aufzurollenden Schicht außerhalb des Steges zwischen 45 bis 135 ° beträgt, nachfolgend die Opferschicht ganz oder teilweise entfernt und der Schichtstapel aufgerollt wird.

4. Verfahren nach Anspruch 1, bei dem als Substrat ein starres oder flexibles Material eingesetzt wird.

5. Verfahren nach Anspruch 1, bei dem ein Substrat aus Silizium, Siliziumoxid, Glas, Keramik oder eine Folie aus Polyethylenterephthalat (PET) oder Polyetheretherketon (PEEK) und eine Opferschicht aus Polyvinylalkohol (PVA), Polyacrylsäure (PAA), Biopolysaccharide, Celluloseacetat, Polyallylamin (PAH), Methylcellulose oder Ethylcellulose eingesetzt wird.

6. Verfahren nach Anspruch 1, bei dem als Funktionsschichten Schichten aus einem elektrisch leitenden Material und als Isolationsschichten Schichten aus einem dielektrischen und/oder elektrisch isolierenden Material mittels Atomlagenabscheidung und/oder chemischer Gasphasenabscheidung aufgebracht werden.

7. Verfahren nach Anspruch 1, bei dem ein Schichtstapel auf die Opferschicht aufgebracht wird, der aus einer Schicht aus mindestens einem dielektrischen und/oder elektrisch isolierenden Material, einer Schicht aus mindestens einem ersten elektrisch leitenden Material, einer weitere Schicht aus mindestens einem dielektrischen und/oder elektrisch isolierenden Material und einer Schicht aus mindestens einem zweiten elektrisch leitenden Material besteht, und bei dem die Schichten aus dem dielektrischen und/oder elektrisch isolierenden Material die Schichten aus dem elektrisch leitenden Material im Wesentlich vollständig bedecken, wobei vorteilhafterweise als Material für elektrisch leitfähige Schichten Ti, Cr, Al, Au, Ni, Pd, Cu, W, Ta sowie deren Verbindungen, oder Indiumzinnoxid oder hochdotiertes Halbleitermaterial eingesetzt wird.

8. Verfahren nach Anspruch 1, bei dem als Material für dielektrische und/oder isolierende Schichten AlOₓ, vorteilhafterweise Al₂O₃, SiOₓ, vorteilhafterweise SiO₂, AlTiOₓ, SiTiOₓ, HfOₓ, TaOₓ, ZrOₓ, HfSiOₓ, ZrSiOₓ, TiZrOₓ, TiZrWOₓ, TiOₓ, SrTiOₓ, PbTiOₓ, SiAlOₓ, Metallnitride, wie Aluminiumnitride AlN_{y}, Siliziumnitride SiN_{y}, AlScN_{y}, Metalloxynitride, wie Aluminiumoxynitride AlOₓN_{y}, Siliziumoxynitride SiOₓN_{y}, HfSiOₓN_{y} und/oder SiC_{z}OₓN_{y} eingesetzt wird.

9. Verfahren nach Anspruch 1, bei dem mindestens eine Schicht, die direkt auf die Opferschicht aufgebracht wird, eine Aufrolllänge von 1 mm bis 30 mm aufweist.

10. Verfahren nach Anspruch 1, bei der Funktions- und Isolationsschichten übereinander auf der Opferschicht angeordnet werden, die an beiden Seiten parallel zur Rollrichtung hinsichtlich Anzahl und Geometrie der Stege die gleiche stegartige Strukturierung aufweisen.

11. Verfahren nach Anspruch 1, bei dem Funktions- und Isolationsschichten aufgebracht werden, bei denen die Seite der Stege, die im Wesentlichen parallel zur Rollrichtung der Schichten angeordnet und Bestandteil des Randes der aufzurollenden Schicht sind, eine Seitenlänge (B) von 10 bis 200 µm aufweisen.

12. Verfahren nach Anspruch 1, bei dem Funktions- und Isolationsschichten aufgebracht werden, bei denen die Seite der Stege, die parallel zur Rollrichtung der Schichten angeordnet ist und nicht Bestandteil des Randes der aufzurollenden Schicht ist, oder eine Ecke der Stege in einem Abstand (H) zum Rand der aufzurollenden Schicht von 10 bis 50 µm angeordnet sind.

13. Verfahren nach Anspruch 1, bei dem Funktions- und Isolationsschichten aufgebracht werden, bei denen der Abstand (D) zwischen den Stegen in Rollrichtung 20 bis 500 µm beträgt.

14. Verfahren nach Anspruch 1, bei dem Funktions- und Isolationsschichten aufgebracht werden, bei denen der Winkel (α) zwischen der Seite des Vierecks der Stege, der zuerst in Rollrichtung vorhanden ist, und dem Rand der aufzurollenden Schicht außerhalb des Vierecks zwischen 30 bis 120 °, noch vorteilhaftweise 45 °, und der Winkel (β) zwischen der Seite des Vierecks der Stege, der zuletzt in Rollrichtung vorhanden ist, und dem Rand der aufzurollenden Schicht außerhalb des Vierecks zwischen 80 bis 120 °, noch vorteilhafterweise 90 ° beträgt.

15. Verfahren nach Anspruch 1, bei dem die Opferschicht mittels Ätzens oder mittels organischer Lösungsmittel und/oder Wasser und/oder Ethylendiamintetraessigsäure entfernt wird.

## Claims

1. Process for the production of a rolled-up component where at least two mutually superposed functional and insulation layers are applied to a substrate with a sacrificial layer, and then the sacrificial layer is entirely or to some extent removed and the layer stack is rolled up, **characterized in that** at least the functional or insulation layer that is arranged directly on the sacrificial layer has a perforation at least at the two sides that are in essence arranged parallel to the direction of roll, and the removal, entirely or to some extent, of the sacrificial layer causes automatic roll-up of the layer stack, where the perforation provides a preferential location for fracture.

2. Process according to Claim 1, where the perforation consists of a segment-type structuring and the basic shape of the segments is tetragonal.

3. Process according to Claim 2, where within the tetragonal basic shape of the segments one of the sides of the segments is in essence arranged parallel to the direction of roll of the layers and is a constituent of the edge of the layer that is to be rolled up and has a side length (B) of 1 to 1000 µm, and the other side of the segments is in essence arranged parallel to the direction of roll of the layers at a distance (H) of 5 to 200 µm from the edge of the layer that it is to be rolled up, and the distance between the segments is 20 to 4000 µm, and the angle (α) between that side of the segments that is encountered first in the direction of roll and the edge of the layer that is to be rolled up, outside of the segment, is between 15 and 135°, and the angle (β) between that side of the segments that is encountered last in the direction of roll and the edge of the layer that is to be rolled up, outside of the segment, is between 45 and 135°, and subsequently the sacrificial layer is removed entirely or to some extent and the layer stack is rolled up.

4. Process according to Claim 1, where a rigid or flexible material is used as substrate.

5. Process according to Claim 1, where a substrate made of silicon, silicon oxide, glass or ceramic is used, or a film made of polyethyleneterephthalate (PET) or polyetheretherketone (PEEK) is used, and a sacrificial layer made of polyvinyl alcohol (PVA), polyacrylic acid (PAA), biopolysaccharide, cellulose acetate, polyallylamine (PAH), methylcellulose or ethylcellulose is used.

6. Process according to Claim 1, where layers made of an electrically conductive material are applied as functional layers and layers made of a dielectric and/or electrically insulating material are applied as insulation layers by means of atomic layer deposition and/or chemical gas-phase deposition.

7. Process according to Claim 1, where a layer stack is applied to the sacrificial layer and consists of a layer made of at least one dielectric and/or electrically insulating material, a layer made of at least one first electrically conductive material, a further layer made of at least one dielectric and/or electrically insulating material and a layer made of at least one second electrically conductive material, and where the layers made of the dielectric and/or electrically insulating material in essence completely cover the layers made of the electrically conductive material, where advantageously Ti, Cr, Al, Au, Ni, Pd, Cu, W, Ta, or else compounds of these, or indium tin oxide or heavily doped semiconductor material is/are advantageously used as material for electrically conductive layers.

8. Process according to Claim 1, where AlOₓ advantageously Al₂O₃, SiOₓ, advantageously SiO₂, AlTiOₓ, SiTiOₓ, HfOₓ, TaOₓ, ZrOₓ, HfSiOₓ, ZrSiOₓ, TiZrOₓ, TiZrWOₓ, TiOₓ, SrTiOₓ, PbTiOₓ, SiAlOₓ, metal nitrides, for example aluminium nitrides AlN_{y}, silicon nitride SiN_{y}, AlScN_{y}, metal oxynitrides, for example aluminium oxynitrides AlOₓN_{y}, silicon oxynitrides SiOₓN_{y}, HfSiOₓN_{y} and/or SiC_{z}OₓN_{y} is/are used as material for dielectric and/or insulating layers.

9. Process according to Claim 1, where the roll-up length of at least one layer which is applied directly to the sacrificial layer is 1 mm to 30 mm.

10. Process according to Claim 1, where functional and insulation layers are mutually superposed on the sacrificial layer and, on both sides parallel to the direction of roll, have the same segment-type structuring in respect of number and geometry of the segments.

11. Process according to Claim 1, where functional and insulation layers are applied and the side length (B) of that side of the segments that is arranged in essence parallel to the direction of roll of the layers and that is a constituent of the edge of the layer to be rolled up is 10 to 200 µm.

12. Process according to Claim 1, where functional and insulation layers are applied and within these that side of the segments that is arranged parallel to the direction of roll of the layers and is not a constituent of the edge of the layer that is to be rolled up is arranged at a distance (H) of 10 to 50 µm from the edge of the layer that is to be rolled up, or a corner of the segments is so arranged.

13. Process according to Claim 1, where functional and insulation layers are applied, and the distance (D) between the segments in the direction of roll is 20 to 500 µm.

14. Process according to Claim 1, where functional and insulation layers are applied, and within these the angle (α) between that side of the quadrilateral of the segments that is encountered first in the direction of roll and the edge of the layer that is to be rolled up, outside of the quadrilateral, is between 30 and 120°, more advantageously 45° and the angle (β) between that side of the quadrilateral of the segments that is encountered last in the direction of roll and the edge of the layer that is to be rolled up, outside of the quadrilateral, is between 80 and 120°, more advantageously 90°.

15. Process according to Claim 1, where the sacrificial layer is removed by means of etching or by means of organic solvents and/or water and/or ethylenediaminetetraacetic acid.

## Revendications

1. Procédé pour la fabrication d'un composant enroulé, dans lequel au moins deux couches fonctionnelles et d'isolation agencées l'une sur l'autre sont appliquées sur un substrat présentant une couche sacrificielle et la couche sacrificielle est ensuite éliminée totalement ou partiellement et la pile de couches est enroulée, **caractérisé en ce qu'**au moins la couche fonctionnelle ou d'isolation, qui est agencée directement sur la couche sacrificielle, présente au moins sur les deux côtés qui sont agencés de manière sensiblement parallèle au sens d'enroulement une perforation et suite à l'élimination totale ou partielle de la couche sacrificielle, la pile de couches s'enroule d'elle-même, la perforation agissant comme point de rupture.

2. Procédé selon la revendication 1, dans lequel la perforation est constituée par une structuration de type nervures et les nervures présentent une forme de base quadrilatérale.

3. Procédé selon la revendication 2, dans lequel, dans le cas de la forme de base quadrilatérale des nervures, un des côtés des nervures est agencé de manière sensiblement parallèle au sens d'enroulement des couches et fait partie du bord de la couche à enrouler et présente une longueur latérale (B) de 1 à 1000 µm et l'autre côté des nervures est agencé de manière sensiblement parallèle au sens d'enroulement des couches à une distance (H) de 5 à 200 µm par rapport au bord de la couche à enrouler et la distance entre les nervures est de 20 à 4000 µm et l'angle (α) entre le côté des nervures qui est d'abord présent dans le sens d'enroulement et le bord de la couche à enrouler en dehors de la nervure se situe entre 15 et 135° et l'angle (β) entre le côté des nervures qui est présent en dernier dans le sens d'enroulement et le bord de la couche à enrouler en dehors de la nervure se situe entre 45 et 135° et ensuite la couche sacrificielle est éliminée totalement ou partiellement et la pile de couches est enroulée.

4. Procédé selon la revendication 1, dans lequel un matériau rigide ou souple est utilisé comme substrat.

5. Procédé selon la revendication 1, dans lequel un substrat constitué par du silicium, de l'oxyde de silicium, du verre, de la céramique ou une feuille en poly(téréphtalate d'éthylène) (PET) ou en polyétheréthercétone (PEEK) et par une couche sacrificielle en poly(alcool vinylique) (PVA), en poly(acide acrylique) (PAA), en biopolysaccharides, en acétate de cellulose, en polyallylamine (PAH), en méthylcellulose ou en éthylcellulose est utilisé.

6. Procédé selon la revendication 1, dans lequel, en tant que couches fonctionnelles, des couches constituées par un matériau électriquement conducteur et, en tant que couches isolantes, des couches constituées par un matériau diélectrique et/ou électriquement isolant, sont appliquées par dépôt de couches atomiques et/ou par dépôt chimique en phase gazeuse.

7. Procédé selon la revendication 1, dans lequel une pile de couches, qui est constituée par une couche constituée par au moins un matériau diélectrique et/ou électriquement isolant, une couche constituée par au moins un premier matériau électriquement conducteur, une autre couche constituée par au moins un matériau diélectrique et/ou électriquement isolant et une couche constituée par au moins un deuxième matériau électriquement conducteur, est appliquée sur la couche sacrificielle et dans lequel les couches en matériau diélectrique et/ou électriquement isolant recouvrent de manière sensiblement complète les couches en matériau électriquement conducteur, du Ti, du Cr, de l'Al, de l'Au, du Ni, du Pd, du Cu, du W, du Ta ainsi que leurs composés ou de l'oxyde d'indium-étain ou un matériau semi-conducteur hautement dopé étant utilisé avantageusement comme matériau pour les couches électriquement conductrices.

8. Procédé selon la revendication 1, dans lequel on utilise, comme matériau pour les couches diélectriques et/ou isolantes, du AlOₓ, avantageusement du Al₂O₃, du SiOₓ, avantageusement du SiO₂, du AlTiOₓ, du SiTiOₓ, du HfOₓ, du TaOₓ, du ZrOₓ, du HfSiOₓ, du ZrSiOₓ, du TiZrOₓ, du TiZrWOₓ, du TiOₓ, du SrTiOₓ, du PbTiOₓ, du SiAlOₓ, des nitrures métalliques, tels que des nitrures d'aluminium AlN_{y}, des nitrures de silicium SiN_{y}, du AlScN_{y}, des oxynitrures métalliques, tels que les oxynitrures d'aluminium AlOₓN_{y}, des oxynitrures de silicium SiOₓN_{y}, du HfSiOₓN_{y} et/ou du SiC_{z}OₓN_{y}.

9. Procédé selon la revendication 1, dans lequel au moins une couche, qui est appliquée directement sur la couche sacrificielle, présente une longueur d'enroulement de 1 mm à 30 mm.

10. Procédé selon la revendication 1, dans lequel des couches fonctionnelles et d'isolation, qui présentent sur les deux côtés parallèles au sens d'enroulement la même structuration de type nervure en ce qui concerne le nombre et la géométrie des nervures, sont agencées les unes sur les autres sur la couche sacrificielle.

11. Procédé selon la revendication 1, dans lequel des couches fonctionnelles et d'isolation, pour lesquelles les côtés des nervures qui sont agencés de manière sensiblement parallèle au sens d'enroulement des couches et qui font partie du bord de la couche à enrouler, présentent une longueur de côté (B) de 10 à 200 µm, sont appliquées.

12. Procédé selon la revendication 1, dans lequel des couches fonctionnelles et d'isolation, pour lesquelles le côté des nervures qui est agencé de manière sensiblement parallèle au sens d'enroulement des couches et qui ne fait pas partie du bord de la couche à enrouler, ou un angle des nervures, est agencé à une distance (H) par rapport au bord de la couche à enrouler de 10 à 50 µm, sont appliquées.

13. Procédé selon la revendication 1, dans lequel des couches fonctionnelles et d'isolation, pour lesquelles la distance (D) entre les nervures dans le sens d'enroulement est de 20 à 500 µm, sont appliquées.

14. Procédé selon la revendication 1, dans lequel des couches fonctionnelles et d'isolation, pour lesquelles l'angle (α) entre le côté du quadrilatère des nervures, qui est d'abord présent dans le sens d'enroulement, et le bord de la couche à enrouler en dehors du quadrilatère est de 30 à 120°, plus avantageusement de 45°, et l'angle (β) entre le côté du quadrilatère des nervures qui est présent en dernier dans le sens d'enroulement et le bord de la couche à enrouler en dehors du quadrilatère est de 80 à 120°, plus avantageusement de 90°, sont appliquées.

15. Procédé selon la revendication 1, dans lequel la couche sacrificielle est éliminée par décapage ou au moyen de solvants organiques et/ou d'eau et/ou d'acide éthylènediaminetétraacétique.
